(19) Europäisches Patentamt

European Patent Office

Office européen des brevets

(11) **EP 1 628 339 A1**

(12) **EUROPEAN PATENT APPLICATION**

(43) Date of publication:
**22.02.2006 Bulletin 2006/08**

(51) Int Cl.:
***H01L 21/762*** (2006.01)

(21) Application number: **05291636.8**

(22) Date of filing: **01.08.2005**

(84) Designated Contracting States:
**AT BE BG CH CY CZ DE DK EE ES FI FR GB GR
HU IE IS IT LI LT LU LV MC NL PL PT RO SE SI
SK TR**
Designated Extension States:
**AL BA HR MK YU**

(30) Priority: **19.08.2004 FR 0408980**

(71) Applicant: **S.O.I.Tec Silicon on Insulator
Technologies
38190 Bernin (FR)**

(72) Inventors:
• **Ben Mohamed, Nadia
38140 Renage (FR)**
• **Maunand Tussot, Corinne
38240 Meylan (FR)**
• **Maleville, Christophe
38660 La Terrasse (FR)**

(74) Representative: **Texier, Christian et al
Cabinet Régimbeau
20, rue de Chazelles
75847 Paris cedex 17 (FR)**

(54) **Heat treatment prior to bonding two wafers**

(57)    A method of transferring a layer from a first wafer
to a second wafer, the first wafer comprising a zone of
weakness defining, with a surface of the first wafer, a
layer of material selected from semiconductor materials
having a thickness that is close to or greater than the
thickness of the layer to be transferred, characterized in
that it comprises the following steps:

a) bringing the surfaces of the two wafers into contact
so that the layer having a thickness that is close to
or greater than the thickness of the layer to be transferred is in contact with the second wafer;
b) supplying heat energy at a first temperature that
is substantially higher than ambient temperature for
a first time period;
c) supplying additional heat energy to increase the
temperature above the first temperature to detach
the layer to be transferred from the first wafer at the
zone of weakness.

The invention also provides an application of said meth-
od.

FIG.4c

EP 1 628 339 A1

## Description

The present invention relates to transferring a layer of semiconductor material from a first wafer to a second wafer to produce a final structure for microelectronics, optics or optoelectronics, such as a semiconductor-on-insulator structure.

Typically, such a layer transfer comprises the following steps:

- forming a zone of weakness in the first wafer at a depth that is close to or greater than the thickness of the layer to be transferred, by implanting an atomic species or by forming a porous layer, or by using any other method that can locally weaken the mechanical bonds in the first wafer;
- bringing the surfaces of the two wafers into contact so that the layer to be transferred is in contact with the second wafer;
- supplying energy to detach the layer to be transferred from the first wafer at the zone of weakness.

Additional heat treatment, also known as a "stabilizing anneal", can then be carried out to improve bonding between the second wafer and the transferred layer.

One difficulty with that kind of layer transfer lies in the fact that organic or inorganic contaminants or gas pockets may become trapped at the interface of the two wafers during step a) and can deleteriously affect the efficiency and quality of their bonding and thus the quality of the desired final structure.

This applies in particular when, in addition to the bonding, one or more particular treatments is/are carried out close to the bonding interface in order to modify the mechanical, physical, or chemical properties of the two wafers.

This applies in particular with treatments comprising atomic species implantation carried out prior to bonding close to a surface to be bonded to form said zone of weakness (the method known as "Smart-Cut®"). On bonding in those circumstances, such contaminants or gas pockets may cause superficial blisters on the implanted wafer and/or may lead to zones which are not transferred during detachment, between the zone at which the species were implanted and the interface between the wafers.

Such defects, which are at or close to the surface of the wafer, are usually reduced little or not at all in number during the stabilizing anneal heat treatment.

When carrying out said "SmartCut®" process, those defects can perturb the structural properties of the layer which has been detached, or at the defect location, they may cause detachment to occur at the bonding interface and not at the implanted zone, thus creating "non-transferred" zones, thereby causing structural defects in the removed layer.

It is known that when such defects are detected after contact, some of said deflects can be removed by unbonding the two wafers by applying suction to the back face, then by cleaning the wafers again, and finally by rebonding.

As an example, it is possible to clean by scrubbing, using a wafer cleaner also known as a scrubber.

However, although it appears to be effective, that technique necessitates unbonding wafers and a mechanical or chemical action on the surfaces, entailing the conventional risks involved in manipulation.

In a first aspect, the present invention seeks to improve the situation by providing a method of transferring a layer from a first wafer to a second wafer, the first wafer comprising a zone of weakness defining, with a surface of the first wafer, a layer of material selected from semiconductor materials having a thickness that is close to or greater than the thickness of the layer to be transferred, characterized in that it comprises the following steps:

a) bringing the surfaces of the two wafers into contact so that the layer having a thickness that is close to or greater than the thickness of the layer to be transferred is in contact with the second wafer;
b) supplying heat energy at a first temperature that is substantially higher than ambient temperature in the range 200°C to 400°C for a first time period greater of about 30 minutes;
c) supplying additional heat energy to increase the temperature above the first temperature to detach the layer to be transferred from the first wafer at the zone of weakness.

Other preferred aspects of the bonding method are as follows:

- following step c), the method further comprises another step consisting of supplying heat energy at a second temperature that is substantially higher than the first temperature for a second time period, to reinforce the bonding linkages between the two wafers;
- the second temperature is about 500°C;
- the heat energy of step c) is supplied in a substantially progressive manner between the first and second temperatures;
- the heat energy supplied is such that the temperature increases continuously over time with a ramp-up that is greater than about 0.5°C/minute (°C/min);
- the first temperature is about 350°C;
- the first time period is less than about 360 min, and particularly less than about 120 min;
- prior to step a), an additional step is carried out and consists of forming a layer of bonding material on one of the two wafer surfaces to be bonded;
- the bonding material is an electrical insulator;
- the bonding material is $SiO_2$;
- at least one of the two surfaces to be bonded has undergone a cleaning step prior to step a);
- the cleaning step employs at least one of the following cleaning techniques: chemical treatment, rinsing, scrubbing;

- prior to step a), the method further comprises a step for forming the zone of weakness in the first wafer; and

- the zone of weakness is formed by atomic species implantation.

In a second aspect, the invention provides an application of said take-off method of the invention to producing a SOI structure.

Other aspects, aims, and advantages of the invention are described below in this document and are illustrated in the following figures:

Figure 1 shows a technique for measuring the bonding energy of two wafers;
Figure 2 is a graphical comparison of the mean bonding energies measured for two wafers that have undergone a prior treatment with no pre-anneal and a prior treatment with a pre-anneal;
Figure 3 shows a temperature-time profile during implementation of a method in accordance with the invention;
Figures 4a to 4c show the principal steps in a method of taking off a useful layer in accordance with the invention;
Figure 5 shows the results of measuring the number of transfer defects in a useful layer taken from two bonded wafers that have undergone a pre-anneal for two hours and two bonded wafers that have undergone a thirty minute pre-anneal.

A principal object of the present invention is to reduce the significance of defects and surface roughness of a thin layer that has been disunited (or detached) from a first wafer (termed the "donor wafer") at an existing zone of weakness during transfer of said thin layer from said donor wafer to a second wafer (termed the "receptor wafer").

After forming the zone of weakness in the donor wafer, for example by atomic species implantation as described below, steps for bonding the two wafers and detaching a thin layer are than carried out successively, simultaneously or in overlapping manner, by means of heat treatments.

Prior to bonding and prior to detachment, techniques for cleaning the surfaces of the wafers to be bonded are advantageously carried out, such as scrubbing, chemical treatments such as RCA treatments, ozonated water or CARO, or successive rinses.

These surface finishing operations have the dual aims of:

• withdrawing particles from the surface;
• energetic activation of the surface.

The term "energetic activation" of a surface of a wafer as used here means the activation of potential energies on the surface of the wafers (said potential energies principally being the manifestation of hanging bonds from the surface atoms) that can become energies for bonding with other particles which will come close to the surface.

Then, when two wafers with respective bonding surfaces that have been treated in this way are contacted, adhesion of the two wafers is obtained.

Said adhesion is mostly of the molecular interaction type between hydrogen atoms present on the surfaces of the wafers to be bonded.

Molecular bonding is facilitated because of the hydrophilic nature of the surfaces to be bonded.

In accordance with the invention, heat treatments are then carried out.

At the interface between the wafers, the properties and physicochemical connections of the surface atoms differ depending on the temperature and time conditions to which the wafers are subjected.

At ambient temperature, water molecules present at the interface between the wafers are free to diffuse and they will bond with hanging bonds from the surface silicon atoms in the form of OH radicals.

The set of hydrogen bonds between the OH radicals will then constitute said molecular bonding between the wafers at their interface.

An increase in bond strength has also been observed for temperatures higher than 1000°C, especially in the studies carried out by W.P. Maszara in the document entitled "Silicon-on-Insulator by Wafer Bonding" (J Electrochem Soc, vol 138, p 341 (1991)). This was principally derived from the formation of Si-O-Si bonds replacing hydrogen-bond molecular bonding at the wafer interface.

Between these two limiting temperature values (ambient temperature and 1000°C), and for a temperature of more than about 200°C, the Applicant has observed that water is no longer really free to diffuse between the wafers, and water molecules are principally formed following modifications to the atomic bonds as follows:

$$Si-OH + Si-OH => Si-O-Si + H_2O$$

Instead of OH bonds which combine to form water molecules, Si-O-Si bonds are created which bind the two wafers together more strongly, thus strengthening the adhesive connections. The higher the temperature, the stronger this phenomenon becomes.

Water molecules formed in the above reaction collect into localized aggregates and will disappear after a certain temperature/time combination.

As an example, for a temperature of 350°C, the Applicant has estimated that the water molecule liberation period is typically of the order of 30 minutes or one hour.

An increase in temperature could evacuate water molecules more rapidly, and avoid problems which may be caused by the presence of said aqueous aggregates.

However, when this temperature increases, the Applicant has also observed an increase in post-detachment roughness values (i.e. at the detachment surface), principally due to thermal phenomena occurring within the zone of weakness when the temperature is increased.

Further, roughness inhomogeneity then occurs. A higher degree of roughness is routinely present at the zone at which wafer detachment is initiated (which is usually the hottest zone), this zone then being termed the "dense zone".

Beyond a few Angstroms (Å) rms (root mean square) of roughness, the degree of roughness can be deemed to be too high for a thin taken-off layer a few 100 Å thick. However, this estimation of the "maximum tolerated roughness" principally depends on the desired final technical specifications.

In all cases, the Applicant has observed that an increase in temperature increases the roughness.

The above gives rise to the idea of a threshold temperature beyond which the water aggregates will disappear from the interface of the two wafers and a maximum temperature beyond which the degree of roughness at the detachment surface of the removed layer could potentially become too high.

Heat treatment at a temperature located between these two limiting temperatures could thus improve the bonding quality of the two wafers before the detachment heat treatment has taken place, which treatment will then be carried out at a higher temperature.

Subsequently, in accordance with the invention, after bringing the two wafers into contact with molecular bonding, a second step consists of supplying heat energy to the two wafers adhering together to increase the bonding force and quality, especially by liberating water molecules from the interface, thereby bringing the wafers closer together at the bonding interface.

This first supply of heat energy is thus termed a pre-anneal.

In the above-mentioned circumstances when two silicon wafers are brought into contact, at least one of the wafers being covered in a layer of silica, the pre-anneal temperature is advantageously in the range 200°C to 400°C, and more particularly is about 350°C.

The pre-anneal time period may be in the range from about 10 min to about 360 min, and more particularly between about 30 min and about 120 min.

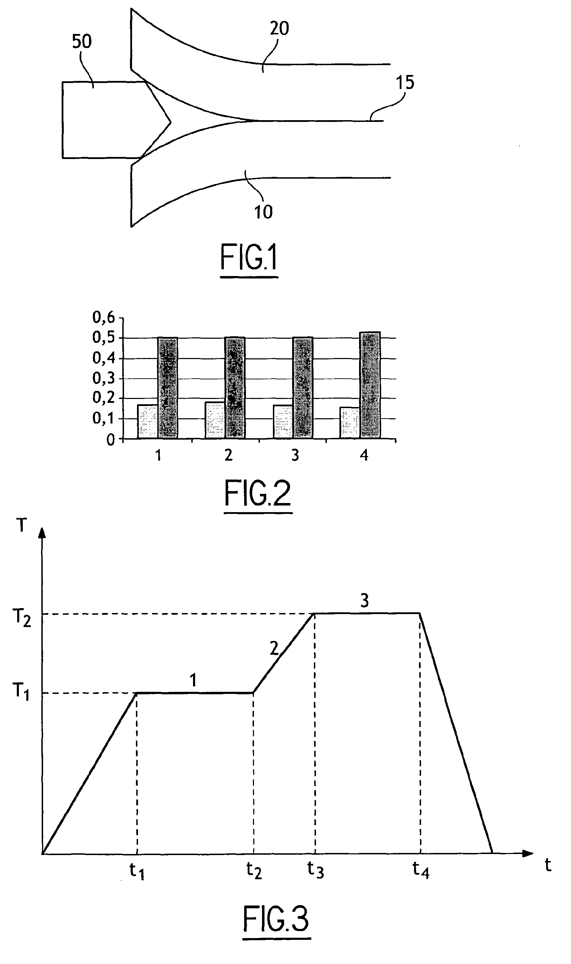

Referring now to Figures 1 and 2, the Applicant has carried out a comparative study of the bonding energy at the interface of two wafers (one of which had already undergone hydrogen atomic species implantation to form a zone of weakness), when no pre-anneal had been carried out and when a pre-anneal had been carried out at 350°C for 30 min.

Referring to Figure 1, the Applicant used an accurate technique for measuring bonding energy proposed by Maszara in the document entitled "Silicon-on-Insulator by Wafer Bonding" (J Electrochem Soc, vol 138, p 341 (1991)).

In accordance with that technique, the Applicant inserted a blade with a thickness of 50 into one or more edges of the assembly of wafers 10 and 20 in contact with each other at the bonding interface 15.

Applying a mechanical force to the blade 50 in a direction substantially parallel to the plane of the interface 15 causes local unbonding of the two wafers 10 and 20 and propagation of the unbonded zone over a certain distance; the length L covered by the bonding wave between the zone locally unbonded by the blade and the point where unbonding stops thus provides information regarding the bonding energy existing between the two wafers 10 and 20.

The unbond stop point corresponds to a balance between the bonding energy and the elastic deformation characterizing unbonding.

A mean bonding energy $\tau$ is calculated from a relationship between the length of the unbonded zone L and the surface energy.

Reference can, for example, be made to the following formula taken from Maszara's document:

$$\tau = \frac{3 \cdot E \cdot t^3 \cdot y^2}{32 \cdot L^4}$$

in which **E** is the Young's modulus of the material present at the interface between the two wafers 10 and 20;
**y** is the half-thickness of the blade;
**t** is the thickness of each wafer.

Figure 2 shows four comparative studies carried out by the Applicant, each of these comparative studies comprising two bonding energy measurements, said two measurements being carried out on substantially identical wafers 10 and 20 which had undergone substantially identical prior surface treatments, and which had been brought into contact under similar conditions.

It is important at this juncture to mention that each measurement in each comparative study was carried out in a manner substantially identical to the other measurements, and in particular that applications of the blade to the interface of wafers 10 and 20 were carried out by exerting substantially identical forces in a substantially identical direction and with a substantially identical blade.

Regarding the reliability of these measurements, it was also important to ensure that the bonding quality was essentially due to the bonding energy between the two wafers and was not perturbed by the presence of residual particles between the wafers.

For this reason, prior to the bonding energy measurements, the Applicant carried out efficient cleaning of the surfaces of the wafers to be bonded.

The graph in Figure 2 shows the bonding energy in joules per square meter ($J/m^2$) up the ordinate; the open columns show the results of measurements made on wafers 10 and 20 in contact with each other which had not undergone a pre-anneal; the solid columns are the measurements carried out on wafers 10 and 20 in contact which had undergone a pre-anneal.

These measurements were carried out on silicon wafers, one of which had been covered with $SiO_2$, the $SiO_2$ layer thus representing the material present at the interface of the two wafers 10 and 20.

The results of four comparative studies show that the bonding energy in the case of a pre-anneal was two to three times higher than in the case in which the wafers 10 and 20 had not been pre-annealed.

The Applicant has thus demonstrated that a pre-anneal at 350°C for 30 min on oxidized silicon wafers substantially increases the bonding forces between the wafers.

After carrying out the pre-anneal, a further heat treatment was carried out at a temperature substantially higher than the first pre-anneal temperature with the aim of disuniting (or detaching) a thin layer from the donor wafer at said zone of weakness existing in the donor wafer, and possibly further reinforcing the bonding connections, especially by increasing the formation of Si-O-Si bonds.

In the aforementioned circumstance of bonding two wafers of silicon covered with silica, an annealing temperature of up to about 500°C was advantageously used.

In accordance with the above explanation, pre-annealing liberated water molecules while reinforcing the bonding interface, but without causing detachment of the thin layer, which allowed the roughness during the subsequent detachment step to be reduced. The pre-anneal also prevented the occurrence of many actual and/or potential defects at the interface of the two wafers; they would have been far more numerous if the detachment heat treatment had been carried out directly.

This improvement in the bonding quality of the two wafers is made particularly clear below in the description of a preferred method in accordance with the invention which has the aim of taking off a thin layer from a donor wafer 10 to transfer it to a receptor wafer 20, in particular by carrying out a method of bonding said two wafers 10 and 20 as described above.

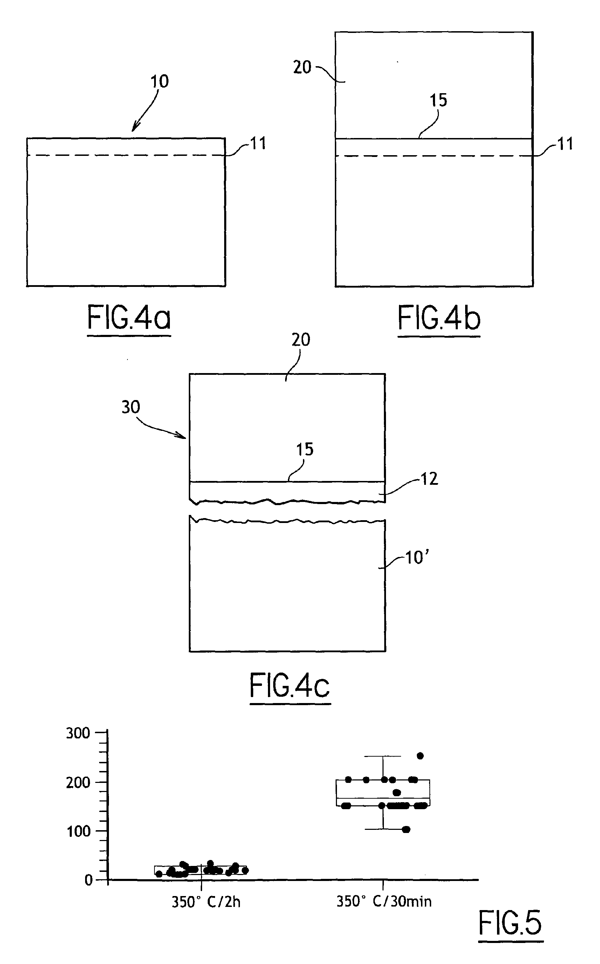

Referring to Figure 4a, a donor wafer 10 comprises a semiconductor material in its upper portion.

Said material comprises silicon or any other semiconductor alloy or material.

In a particular configuration, the surface to be bonded of the donor wafer 10 is covered with an insulating layer.

Said insulator can in particular be $SiO_2$ formed, for example, by thermal oxidation, in particular when the donor wafer 10 comprises silicon at its initial surface.

In a first step of the preferred method of the invention, a zone of weakness 11 is formed in the semiconductor material of the donor wafer 10, weakening corresponding to breaking atomic bonds at the zone of weakness connecting the neighboring portion above the zone of weakness to the neighboring portion below the zone of weakness 11.

The zone of weakness 11 is advantageously formed by atomic species implantation at a predetermined energy and at a predetermined dose, so that it extends substantially parallel to the plane of the surface of the donor wafer 10.

Said atomic species are preferably hydrogen and/or helium.

Referring now to Figure 4b, a receptor 20 is brought into contact with the donor wafer 10 at the interface 15.

Prior cleaning and/or finishing treatment for the surfaces to be bonded is advantageously carried out to clean and smooth the surfaces. This cleaning treatment can comprise moistening the surfaces in contact to create a molecular OH-HO bond between the wafers 10 and 20.

Referring to Figure 3, the assembly of wafers 10 and 20 then undergoes a pre-anneal 1 as described above at a first temperature $T_1$ and for a first predetermined period of time (between time $t_1$ and time $t_2$).

Particularly when the donor wafer 10 is formed from oxidized Si, said pre-anneal 1 can be carried out at a temperature $T_1$ in the range 200°C to 400°C, and more particularly of the order of 350°C, for a period which can span from several minutes to several hours.

Referring now to Figure 4c, a third step consists in supplying energy to the assembly of two bonded wafers to detach the portion 12, which is in contact with the receptor wafer 20, from the donor wafer 10 at the zone of weakness 11.

Said portion 12 then corresponds to the thin layer taken from the donor wafer 10 for transfer to the receptor wafer 20, and in which electronic components will advantageously be produced.

Said supply of energy to detach the useful layer 12 comprises increasing the thermal energy supplied (see 2 in Figure 3) between the first temperature $T_1$ and a second temperature $T_2$.

The increase in temperature is advantageously substantially continuous, and can be more than about 0.5°C/min, typically between about 5°C/min and about 20°C/min for wafers 10 and 20 of silicon, with at least one of them being covered with $SiO_2$.

Detachment (or disuniting) of useful layer 12 will then occur during this progressive temperature increase between a temperature which lies, for example, in the range from about 350°C to about 500°C.

A fourth step consisting of annealing heat treatment is then optionally carried out to reinforce the bonding interface 15.

Referring to Figure 3, said anneal 3 can then consist in applying a temperature $T_2$ that is higher than the temperature at which detachment has occurred, and maintaining said temperature practically constant for a predetermined period (in the range from a time $t_3$ to a time $t_4$).

As an example, it is possible to carry out an anneal 3 at a temperature of about 500°C for about 30 min.

Said anneal 3 then allows the creation of more Si-O-Si bonds (stronger than SiOH-HOSi) bonds).

In another circumstance, an anneal 3 is not carried out, and the temperature can be dropped directly after detachment.

After removing the remaining portion 10' of the donor wafer, an assembly 30 constituting the desired structure is then obtained, preferably with a step for finishing the surface of the useful layer 12 to remove the subsisting roughness and to render its thickness more uniform.

This finishing can be carried out by polishing, CMP, smoothing, heat treatment, chemical etching, abrasion, or particle bombardment, for example.

When the useful layer is formed from silicon, and when the interface 15 is included in an insulating material, then this structure 30 represents an SOI structure.

In this particular circumstance, the remaining donor wafer 10' can be re-used in a further process following a recycling step.

Figure 5 shows a comparative study between the numbers of transfer defects occurring in the useful layer 12 of the structure 30 as measured after taking off and after pre-annealing the initial wafers 10 and 20 at 350°C for two hours, and as measured identically with initial wafers 10 and 20 which have undergone a pre-anneal at 350°C for 30 min.

Wafers 10 and 20 were formed from silicon, with one of them being covered with a layer of $SiO_2$ at the bonding surface.

The ordinates of the graph of Figure 5 represent the number of transfer defects measured per wafer in the two circumstances in which the anneal consisted of continuously increasing the temperature by about 350°C over 2 hours and by about 350°C over 30 minutes, the black spots representing the results of the measurements.

The results of the measurements can be divided into two sections:

- a first section, closer to the origin of the graph, comprising a set of measurements corresponding to two hour pre-anneals;
- a second section, further from the origin of the graph, comprising a set of measurements corresponding to 30 minute pre-anneals.

The mean number of transfer defects for a 2 hour pre-anneal was about 20 while it was of the order of 160 for a 30 minute pre-anneal.

A useful layer which has undergone a pre-anneal for two hours thus has eight times fewer transfer defects on average than a useful layer that has undergone a 30 minute pre-anneal, which shows the major influence of pre-anneal duration on the quality of bonding, a longer duration appearing to improve the quality of bonding.

More generally, the Applicant has shown here the importance of carrying out a pre-anneal in such a method of taking off a useful layer, especially in order to reduce the number of transfer defects that are prejudicial to the quality of the useful layer in which future electronic components will be produced.

The Applicant has not only demonstrated an increase in bonding energy with a pre-anneal, but has also shown that said pre-anneal improves the bonding quality in the sense that it eliminates defects that occur when taking off following a pre-anneal.

The present invention is not limited to bonding two silicon wafers, nor to bonding two silicon wafers at least one of which is covered with silicon; it is applicable to any type of material such as type IV materials or type IV-IV, III-VI or II-VI alloys, which may be binary, ternary or of higher degree.

## Claims

1. A method of transferring a layer from a first wafer to a second wafer, the first wafer comprising a zone of weakness defining, with a surface of the first wafer, a layer of material selected from semiconductor materials having a thickness that is close to or greater than the thickness of the layer to be transferred, **characterized in that** it comprises the following steps:

   a) bringing the surfaces of the two wafers into contact so that the layer having a thickness that is close to or greater than the thickness of the layer to be transferred is in contact with the second wafer;
   b) supplying heat energy at a first temperature that is substantially higher than ambient temperature in the range 200°C to 400°C for a first time period greater of about 30 minutes;
   c) supplying additional heat energy to increase the temperature above the first temperature to detach the layer to be transferred from the first wafer at the zone of weakness.

2. A method according to the preceding claim, further comprising the following step, after step c):

   d) supplying heat energy at a second temperature that is substantially higher than the first temperature for a second time period, to reinforce the bonding linkages between the two wafers.

3. A method according to the preceding claim, wherein the second temperature is about 500°C.

4. A method according to either one of the two preceding claims, wherein the heat energy of step c) is supplied in a substantially progressive manner between the first and second temperatures.

5. A method according to the preceding claim, wherein the heat energy supplied is such that the temperature increases continuously over time with a ramp-up that is more than about 0.5°C/minute.

6. A method according to the preceding claim, wherein the first temperature is about 350°C.

7. A method according to any preceding claim, wherein the first time period is less than about 360 min.

8. A method according to the preceding claim, wherein the first time period is less than about 120 min.

9. A method according to any preceding claim, wherein prior to step a), it comprises a step consisting of forming a layer of bonding material on one of the two wafer surfaces to be bonded.

10. A method according to any one of claims 1 to 8, wherein prior to step a), it comprises a step consisting of forming two layers of bonding material on at least one of the wafer surfaces of the wafers.

11. A method according to either one of the two preceding claims, wherein the bonding material is an electrical insulator.

12. A method according to the preceding claim, wherein the bonding material is $SiO_2$.

13. A method according to any preceding claim, wherein at least one of the two surfaces to be bonded has undergone a cleaning step prior to step a).

14. A method according to the preceding claim, wherein the cleaning step employs at least one of the following cleaning techniques: chemical treatment, rinsing, scrubbing.

15. A method according to any preceding claim, further comprising, prior to step a), a step of forming the zone of weakness in the first wafer.

16. A method according to the preceding claim, wherein the zone of weakness is formed by atomic species implantation.

17. Application of a method according to any preceding claim, for the production of a SOI structure.

FIG.1

FIG.2

FIG.3

FIG.4a

FIG.4b

FIG.4c

FIG.5

**European Patent Office**

## EUROPEAN SEARCH REPORT

Application Number

EP 05 29 1636

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 1 359 615 A (SOITEC SILICON ON INSULATOR) 5 November 2003 (2003-11-05) | 1-11, 15-17 | H01L21/762 |
| Y | * column 1, paragraph 1-7 * <br> * column 7, paragraph 54 - column 9, paragraph 84; figure 5 * <br> ----- | 12-14 | |
| Y | US 2002/047169 A1 (KUNIKIYO TATSUYA) 25 April 2002 (2002-04-25) <br> * page 15, paragraph 317 - page 15, paragraph 321; figures 2a-7b * <br> ----- | 12-14 | |
| A | EP 1 429 381 A (COMMISSARIAT ENERGIE ATOMIQUE ; SOITEC SILICON ON INSULATOR (FR)) 16 June 2004 (2004-06-16) <br> * abstract * <br> ----- | 1-17 | |

TECHNICAL FIELDS
SEARCHED       (IPC)

H01L

The present search report has been drawn up for all claims

| Place of search | Date of completion of the search | Examiner |
|---|---|---|
| The Hague | 17 November 2005 | Hedouin, M |

EPO FORM 1503 03.82 (P04C01)

## ANNEX TO THE EUROPEAN SEARCH REPORT
## ON EUROPEAN PATENT APPLICATION NO.

EP 05 29 1636

This annex lists the patent family members relating to the patent documents cited in the above-mentioned European search report.
The members are as contained in the European Patent Office EDP file on
The European Patent Office is in no way liable for these particulars which are merely given for the purpose of information.

17-11-2005

| Patent document cited in search report | | Publication date | Patent family member(s) | | Publication date |
|---|---|---|---|---|---|
| EP 1359615 | A | 05-11-2003 | CN | 1479353 A | 03-03-2004 |
| | | | FR | 2839385 A1 | 07-11-2003 |
| | | | JP | 2003347526 A | 05-12-2003 |
| | | | US | 2003216008 A1 | 20-11-2003 |
| US 2002047169 | A1 | 25-04-2002 | CN | 1340862 A | 20-03-2002 |
| | | | DE | 10115489 A1 | 28-03-2002 |
| | | | JP | 2002076336 A | 15-03-2002 |
| | | | TW | 518759 B | 21-01-2003 |
| EP 1429381 | A | 16-06-2004 | NONE | | |

EPO FORM P0459

For more details about this annex : see Official Journal of the European Patent Office, No. 12/82